# EUROPEAN PATENT APPLICATION

(11) **EP 4 836 665 A1**
(43) Date of publication of application: **04.11.2026**
(21) Application number: 26164145.0
(22) Date of filing: 12.03.2026
(51) Int. Cl.: H10P 58/00, H10W 42/00

(54) **SEMICONDUCTOR DEVICE**

(30) Priority: 02.05.2025 KR 20250058001
(71) Applicant: SK hynix Inc., Bubal-eub Icheon-si Gyeonggi-do 17336 (KR)
(72) Inventor: CHANG, Heon Yong, 17336 Icheon-si, Gyeonggi-do (KR)
(74) Representative: Isarpatent

(57) **Abstract**

A semiconductor device is provided in accordance with embodiments of the present disclosure. The semiconductor device may include: a substrate including a chip region and a scribe lane region, the scribe lane region including a first boundary adjacent to the chip region and a second boundary spaced apart from the first boundary; a plurality of first trenches located between the first boundary and the second boundary, disposed in a first direction parallel to the first boundary, and having a first width in the first direction; and at least one second trench segment having a second width in the first direction, the second width being greater than the first width.

## Description

### BACKGROUND

### 1. Technical Field

Embodiments of the present disclosure relate to a semiconductor device.

### 2. Related Art

Due to characteristics such as miniaturization, multifunctionality, and/or low manufacturing cost, semiconductor devices are spotlighted as important components in the electronics industry. As the electronics industry has advanced significantly, semiconductor devices are increasingly required to be highly integrated.

To meet the demand for high integration, semiconductor devices may include a redistribution layer (RDL) pattern. The RDL pattern may be electrically connected to chip pads and may extend from an area in which the chip pads are disposed to other areas.

### SUMMARY

Objects of embodiments of the present disclosure are not limited to those described herein, and other objects not explicitly stated will be apparent to those skilled in the art from the following description.

Embodiments of the present disclosure may provide a semiconductor device capable of preventing degradation of device characteristics caused by process defects.

Embodiments of the present disclosure may provide a semiconductor device comprising: a substrate including a chip region and a scribe lane region, the scribe lane region including a first boundary adjacent to the chip region and a second boundary spaced apart from the first boundary; a plurality of first trenches located between the first boundary and the second boundary, disposed in a first direction parallel to the first boundary, and having a first width in the first direction; and at least one second trench segment having a second width in the first direction, the second width being greater than the first width.

Embodiments of the present disclosure may provide a semiconductor device comprising: a substrate including a chip region and a scribe lane region; a plurality of first trenches disposed in a first direction in the scribe lane region, the first direction being parallel to a first boundary adjacent to both the chip region and the scribe lane region; and at least one second trench segment, at least a portion of which is disposed in a region other than a region between at least two of the plurality of first trenches, wherein the plurality of first trenches has a first width in the first direction, the first width being less than a second width of the at least one second trench segment in the first direction.

Embodiments of the present disclosure may provide a semiconductor device comprising: a substrate including a chip region and a scribe lane region; a plurality of first trench segments disposed in a first direction in the scribe lane region, the first direction being parallel to a first boundary adjacent to both the chip region and the scribe lane region; and at least one second trench segment disposed between at least two of the plurality of first trench segments, wherein each of the plurality of first trench segments has a fourth width in the first direction, the fourth width being less than a second width of the at least one second trench segment in the first direction.

According to embodiments of the present disclosure, degradation of device characteristics of the semiconductor device due to process defects can be prevented.

Effects of embodiments of the present disclosure are not limited to those described above, and additional effects not described will be clearly understood by those skilled in the art from the description of the claims.

### BRIEF DESCRIPTION OF THE DRAWINGS

The present disclosure will be more fully understood from the following detailed description and the accompanying drawings. The detailed description and the drawings are provided for illustrative purposes only and are not intended to limit the scope of the present disclosure.
FIG. 1 is a view illustrating a wafer in which semiconductor devices according to embodiments of the present disclosure are integrated.
FIG. 2 is a plan view illustrating an embodiment of a semiconductor device, showing an enlarged view of region A in FIG. 1.
FIG. 3 is a cross-sectional view illustrating exemplary cross-sections taken along lines I-I' and II-II' of FIG. 2.
FIG. 4 to FIG. 6 are cross-sectional views illustrating a method of manufacturing a semiconductor device according to the embodiment shown in FIG. 2.
FIG. 7 is a plan view illustrating another embodiment of a semiconductor device disclosed in FIG. 1, showing an enlarged view of region A in FIG. 1.
FIG. 8 is a cross-sectional view illustrating an exemplary cross-section taken along line III-III' of FIG. 7.
FIG. 9 and FIG. 10 are plan views illustrating another embodiment of a semiconductor device disclosed in FIG. 1, showing an enlarged view of region A in FIG. 1.
FIG. 11 is a cross-sectional view illustrating an exemplary cross-section taken along line IV-IV' of FIG. 10.

### DETAILED DESCRIPTION

In the following description of examples or embodiments of the present disclosure, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present disclosure, detailed descriptions of well-known functions and components incorporated herein will be omitted when it is determined that the description may make the subject matter in some embodiments of the present disclosure rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present disclosure. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc., each other via a fourth element. The second element may be included in at least one of two or more elements that "are connected or coupled to", "contact or overlap", etc., each other.

When time relative terms, such as "after," "subsequent to," "next," "before," and the like, are used to describe processes or operations of elements or configurations, or flows or steps in operating, processing, manufacturing methods, these terms may be used to describe nonconsecutive or non-sequential processes or operations unless the term "directly" or "immediately" is used together.

In addition, when any dimensions, relative sizes etc., are mentioned, it should be considered that numerical values for elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, various embodiments of the present disclosure will be described in detail with reference to accompanying drawings.

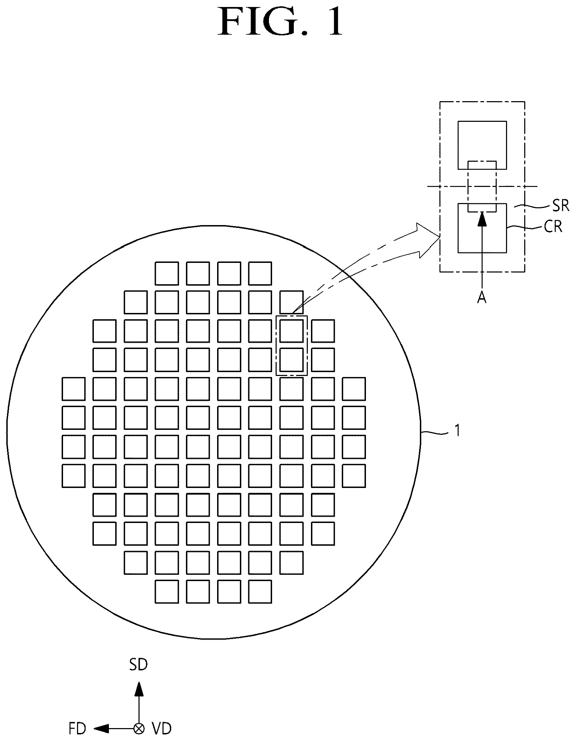

FIG. 1 is a view illustrating a wafer 1 in which semiconductor devices according to embodiments of the present disclosure are integrated.

Referring to FIG. 1, the wafer 1 may include a chip region CR and a scribe lane region SR.

The chip region CR may be a region that becomes an individual semiconductor chip after the wafer 1 is diced. Each chip region CR may include integrated circuits that enable the chip to function as an individual semiconductor device.

A direction parallel to a boundary between the chip region CR and the scribe lane region SR may be defined as a first direction FD. A direction crossing the first direction FD may be defined as a second direction SD. The first direction FD and the second direction SD may be substantially perpendicular to each other.

The scribe lane region SR may extend in the first direction FD and the second direction SD, intersecting each other so as to surround side surfaces of each chip region CR. The scribe lane region SR may be continuous with the chip region CR. The scribe lane region SR may be located outside the chip region CR. The wafer 1 may be diced along cutting lines within the scribe lane region SR using a laser, a blade, or the like during a dicing process. In one embodiment, the cutting lines may be parallel to the first direction FD or the second direction SD.

A partial region of the wafer 1 may include a semiconductor device and an adjacent semiconductor device. A region between the semiconductor device and the adjacent semiconductor device may be defined as region A.

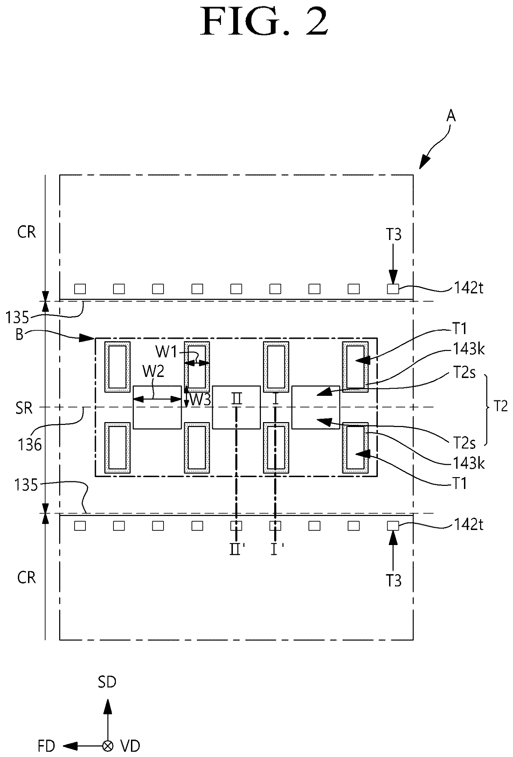

FIG. 2 is a plan view illustrating an embodiment of the semiconductor device and showing an enlarged view of region A in FIG. 1.

Region A may include a partial region of a semiconductor device and a partial region of an adjacent semiconductor device.

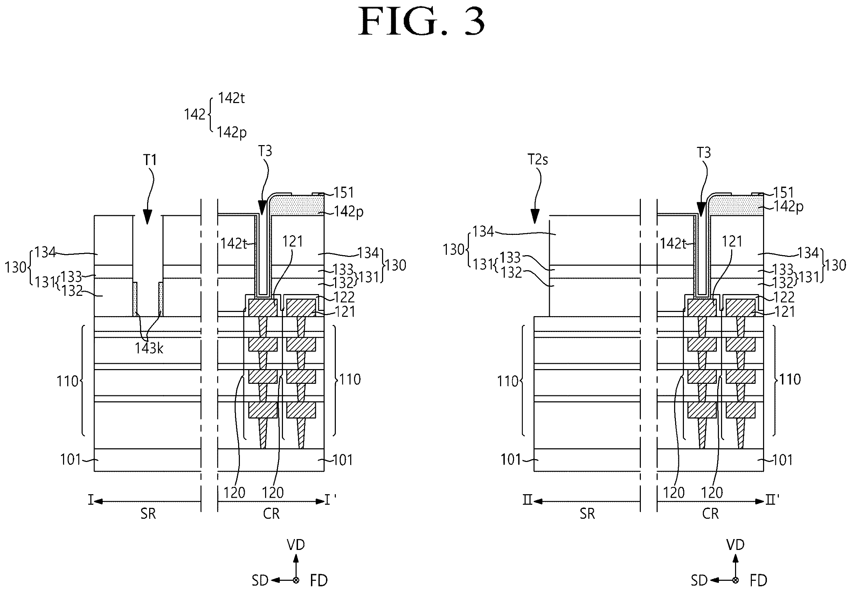

FIG. 3 is a diagram illustrating cross-sectional structures of sections I-I' and II-II' in FIG. 2.

Referring to FIG. 2 and 3, the semiconductor device may include the chip region CR and a part of the scribe lane region SR that is continuous with the chip region CR.

A boundary of the scribe lane region SR that is adjacent to the chip region CR may be defined as a first boundary 135. A boundary spaced apart from the first boundary 135 may be defined as a second boundary 136. The second boundary 136 may be located outward of the first boundary 135.

An alignment key region B may be disposed in a partial region of the scribe lane region SR. The alignment key region B may be defined as a region in which a redistribution alignment key is disposed. The redistribution alignment key may be used for alignment during an etching process of a redistribution pattern layer in the process of manufacturing the semiconductor device.

The alignment key region B may be located between adjacent chip regions CR. Although FIG. 2 illustrates that the alignment key region B is located between chip regions CR that are adjacent in the second direction SD, the location of the alignment key region B is not limited thereto.

A plurality of first trenches T1 may be disposed in the alignment key region B. Each of the plurality of first trenches T1 may be located inside the second boundary 136 (with respect to the semiconductor device). Each of the plurality of first trenches T1 may be arranged in the first direction FD. Because first trenches T1 adjacent to each other in the second direction SD are spaced apart from each other, dicing may proceed in a linear manner during the dicing process. Accordingly, the disclosed embodiments may prevent quality defects such as delamination or cracks during a subsequent packaging process.

An alignment pattern layer 143k may be disposed inside the first trench T1. In one embodiment, the alignment pattern layer 143k may be a part of the redistribution alignment key. The redistribution alignment key may be used for alignment during etching of a redistribution pattern layer in the semiconductor device manufacturing process.

A second trench T2 may be disposed in the alignment key region B. At least one second trench T2 may be disposed between first trenches T1 that are adjacent in the first direction FD. A depth of the second trench T2 may be equal to a depth of the first trench T1. A bottom surface of the second trench T2 may be coplanar with a bottom surface of the first trench T1. By disposing the second trench T2 between first trenches T1 that are adjacent in the first direction FD, dicing may proceed in a linear manner during the dicing process.

After the dicing process is performed, a second trench segment T2s may be formed. A distance between the second trench segment T2s and the first boundary 135 may be greater than a distance between the first trench T1 and the first boundary 135. A portion of the at least one second trench segment T2s may be disposed in a region between at least two of the plurality of first trenches T1. A portion of the at least one second trench segment T2s may also be disposed outside a region between at least two of the plurality of first trenches T1.

A depth of the at least one second trench segment T2s may be equal to a depth of each of the plurality of first trenches T1. A bottom surface of the at least one second trench segment T2s may be coplanar with a bottom surface of each of the plurality of first trenches T1. The second trench segment T2s may be a part of the second trench T2.

A third trench T3 may be disposed in the chip region CR. A redistribution trench portion 142t may be disposed on the third trench T3. A redistribution pad portion 142p may be disposed in the chip region CR. The redistribution pad portion 142p may be continuous with the redistribution trench portion 142t. The redistribution pad portions 142p may be electrically connected to chip pads (not shown) and may extend from a region where the chip pads are disposed to another region.

A redistribution pattern layer 142 may be disposed on the chip region CR. The redistribution pattern layer 142 may include the redistribution trench portion 142t and the redistribution pad portion 142p.

Although FIG. 2 illustrates a limited number of redistribution trench portions 142t, the number is not limited thereto, and various numbers of redistribution trench portions 142t may be disposed. Although FIG. 2 illustrates the redistribution trench portions 142t as being arranged parallel to the first direction FD, the arrangement is not limited thereto.

A device layer 110 may be disposed on a substrate 101. A wiring structure 120 may be disposed on the substrate 101.

The substrate 101 may include a semiconductor substrate such as a silicon wafer or a silicon-on-insulator (SOI) wafer. The substrate 101 may include a group III-V compound semiconductor substrate such as GaAs. The substrate 101 may include single-crystal silicon, polysilicon, amorphous silicon, single-crystal silicon-germanium, polycrystalline silicon-germanium, carbon-doped silicon, or a combination thereof.

The device layer 110 may include silicon oxide, silicon nitride, silicon oxynitride, low-k dielectric materials, high-k dielectric materials, or a combination thereof. The device layer 110 may include an insulating material having excellent step coverage and gap-fill characteristics. In one embodiment, the device layer 110 may include an oxide such as tetraethyl orthosilicate (TEOS) or borophosphosilicate glass (BPSG).

The wiring structure 120 may be disposed in the chip region CR. The wiring structure 120 may penetrate the device layer 110.

The wiring structure 120 may include a wiring layer 121. A plurality of interlayer wiring layers and interlayer wiring contacts connecting them may be disposed beneath the wiring layer 121. The wiring layer 121 may be disposed on the device layer 110. In one embodiment, the wiring layer 121 may include aluminum (Al).

A protective layer 122 may be disposed on the device layer 110 in the chip region CR. The protective layer 122 may be disposed to cover the wiring layer 121. The protective layer 122 may include a silicon nitride film or a silicon oxynitride film. In one embodiment, the protective layer 122 may be formed of TEOS.

A passivation layer 131 may be disposed on the protective layer 122. The passivation layer 131 may include a high-density plasma (HDP) oxide, a nitride, or a combination thereof. The passivation layer 131 may include a passivation oxide layer 132 and a passivation nitride layer 133. The passivation nitride layer 133 may be located on the passivation oxide layer 132. In one embodiment, the passivation oxide layer 132 may include a high-density plasma oxide.

A redistribution insulating layer 134 may be disposed on the passivation layer 131. The redistribution insulating layer 134 may include silicon oxide, silicon nitride, silicon oxynitride, low-k dielectric materials, high-k dielectric materials, or a combination thereof. In one embodiment, the redistribution insulating layer 134 may include an oxide.

An insulating structure 130 may be defined to include the passivation layer 131 and the redistribution insulating layer 134.

A first trench T1 may be disposed on the device layer 110 in the scribe lane region SR. A bottom surface of the first trench T1 may be in contact with a top surface of the device layer 110. A distance between the bottom surface of the first trench T1 and the top surface of the substrate 101 may be less than a distance between the bottom surface of the third trench T3 and the top surface of the substrate 101. The alignment pattern layer 143k may be disposed inside the first trench T1.

Although the alignment pattern layer 143k is illustrated as being disposed only on a portion of a side surface of the first trench T1, it is not limited thereto. Although the alignment pattern layer 143k is illustrated as being disposed only on a portion of a bottom surface of the first trench T1, it is not limited thereto.

The second trench segment T2s may be disposed on the device layer 110 in the scribe lane region SR.

The third trench T3 may be disposed on the wiring layer 121. The third trench T3 may be located inside the insulating structure 130.

The redistribution pattern layer 142 may be disposed on the insulating structure 130 in the chip region CR. The redistribution pattern layer 142 may include the redistribution trench portion 142t and the redistribution pad portion 142p. The redistribution trench portion 142t may be located inside the third trench T3. The redistribution pad portion 142p may be located on a top surface of the insulating structure 130.

A capping layer 151 may be disposed on the redistribution pattern layer 142. The capping layer 151 may be located on the insulating structure 130. In one embodiment, the capping layer 151 may include a nitride.

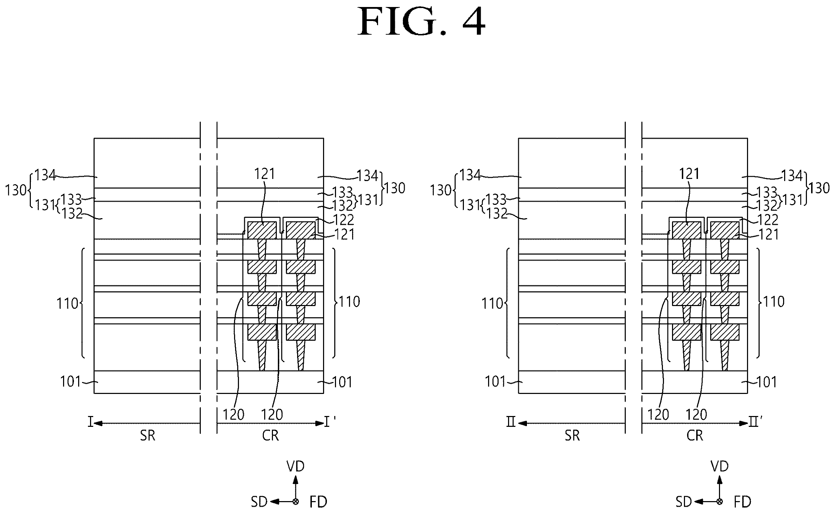

FIG. 4 to FIG. 6 are cross-sectional views illustrating a method of manufacturing a semiconductor device according to the embodiment disclosed in FIG. 2.

Referring to FIG. 4, the device layer 110 may be formed on the substrate 101. The wiring structure 120 may be formed on the substrate 101. The wiring structure 120 may be formed in the chip region CR. The wiring structure 120 may penetrate the device layer 110.

The protective layer 122 and the passivation layer 131 may be sequentially formed on the device layer 110 in the chip region CR. The protective layer 122 may be formed to cover the wiring layer 121. The passivation nitride layer 133 may be formed on the passivation oxide layer 132. The redistribution insulating layer 134 may be formed on the passivation layer 131.

The passivation layer 131 may be formed on the device layer 110 in the scribe lane region SR. The redistribution insulating layer 134 may be formed on the passivation layer 131.

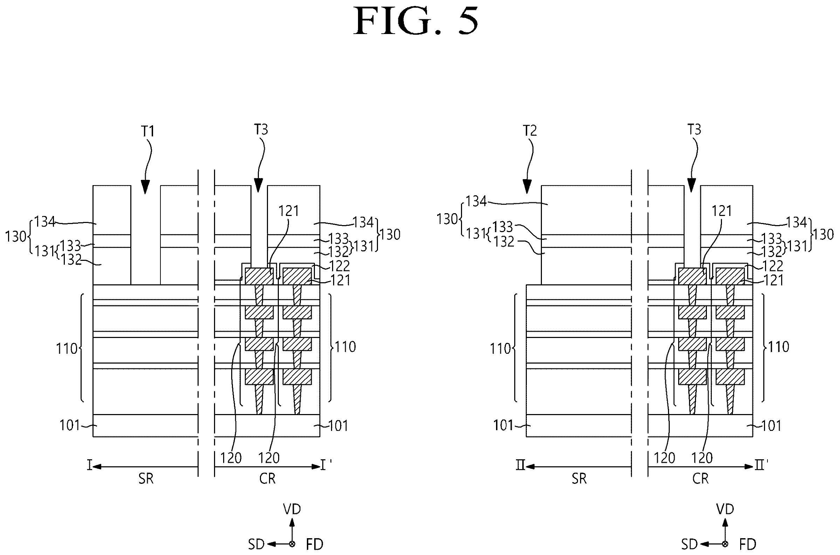

Referring to FIG. 5, the first trench T1 may be formed in the scribe lane region SR. The first trench T1 may be formed by etching the insulating structure 130. In one embodiment, the first trench T1 may be formed by a dry etching process. The first trench T1 may be formed to penetrate the insulating structure 130. During formation of the first trench T1, a portion of a top surface of the device layer 110 may be exposed. A bottom surface of the first trench T1 may be formed to contact the top surface of the device layer 110.

The second trench T2 may be formed in the scribe lane region SR. The second trench T2 may be formed by etching the insulating structure 130. In one embodiment, the second trench T2 may be formed in the same manner as the first trench T1.

When a redistribution alignment key is arranged perpendicular to the dicing direction for alignment during etching of the redistribution pattern layer, the dicing may proceed abnormally. Due to abnormal dicing, the cross-section of the semiconductor chip may become coarse, which may result in issues such as delamination or cracking during a subsequent packaging process. In this embodiment, because a portion of the insulating structure 130 in the dicing region is etched when forming the second trench T2, dicing from the lower portion may proceed more easily.

The second trench T2 may be formed to penetrate the insulating structure 130. During formation of the second trench T2, a portion of a top surface of the device layer 110 may be exposed. A bottom surface of the second trench T2 may be formed to contact the top surface of the device layer 110. Because the bottom surface of the second trench T2 is larger than that of the first trench T1, the straightness of dicing may be improved.

The third trench T3 may be formed in the chip region CR. The third trench T3 may be formed by etching the insulating structure 130. In one embodiment, the third trench T3 may be formed in the same manner as the first trench T1. During formation of the third trench T3, a portion of a top surface of the wiring layer 121 may be exposed. A bottom surface of the third trench T3 may be formed to contact the top surface of the wiring layer 121.

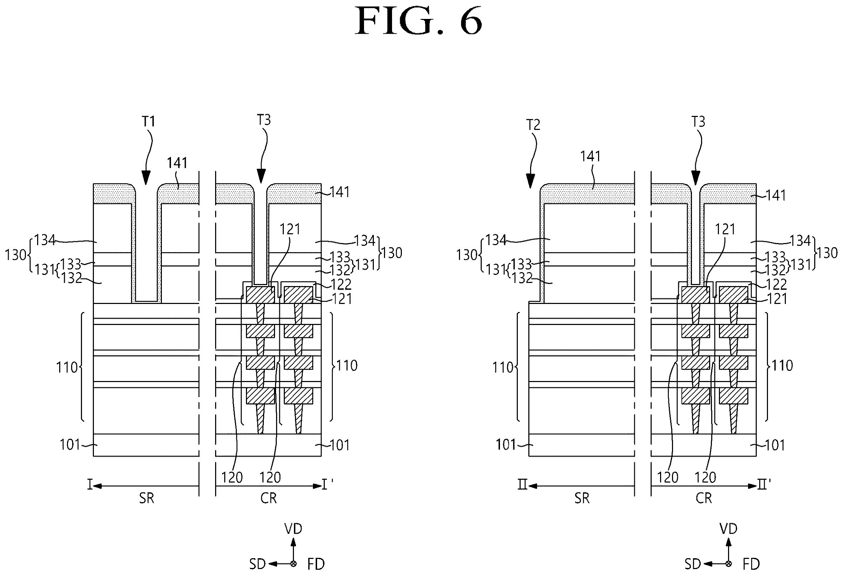

Referring to FIG. 6, a redistribution material 141 may be deposited on the insulating structure 130. The redistribution material 141 may be deposited to cover the first trench T1, the second trench T2, and the third trench T3.

The redistribution material 141 may be formed using a film-forming technique having excellent step coverage, such as chemical vapor deposition (CVD), physical vapor deposition (PVD), or atomic layer deposition (ALD). In one embodiment, the redistribution material 141 may be deposited using the PVD. Before deposition of the redistribution material 141, a barrier material (not shown) may be deposited. In one embodiment, the barrier material may include titanium nitride (TiN).

As the redistribution material 141 is deposited, overhangs may be formed. Accordingly, during a subsequent etching process, the redistribution material may remain inside the first trench T1. The redistribution material 141 may include conductive metal materials such as copper (Cu) or aluminum (Al). In one embodiment, the redistribution material 141 may include aluminum (Al).

Referring again to FIG. 3, the redistribution material 141 may be etched. If the redistribution material 141 remains in the trenches T1 and T2, the dicing may not proceed in a straight manner. In this embodiment, because the second width W2 in the first direction FD is greater than the first width W1 in the same direction, the redistribution material 141 inside the second trench T2 may be removed. Because the bottom surface of the second trench T2 is larger than that of the first trench T1, the redistribution material 141 in the second trench T2 may be removed. Accordingly, the second trench T2 may induce straight dicing.

The alignment pattern layer 143k may be formed inside the first trench T1. The redistribution pattern layer 142 may be formed in the chip region CR. The redistribution pattern layer 142 may be formed inside the third trench T3 and on the insulating structure 130. The redistribution trench portion 142t may be formed inside the third trench T3. The redistribution pad portion 142p may be formed on the insulating structure 130.

The capping layer 151 may be deposited on the alignment pattern layer 143k. In one embodiment, the capping layer 151 may include a nitride. After the capping layer 151 is deposited, a portion of the top surface of the redistribution pad portion 142p may be exposed by an etching process.

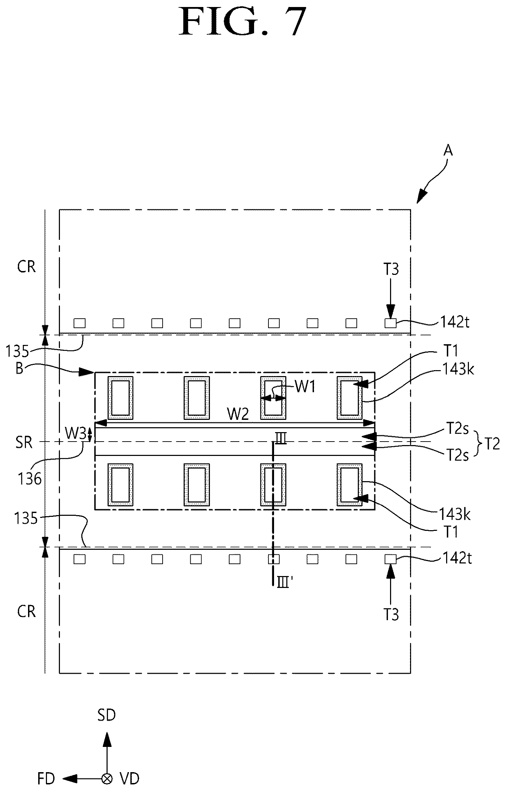

FIG. 7 is a plan view illustrating another embodiment of a semiconductor device disclosed in FIG. 1, showing an enlarged view of region A of FIG. 1.

The semiconductor device shown in FIG. 7 may be formed using the same method as the method of manufacturing a semiconductor device described with reference to FIG. 4 to FIG. 6.

In the following description of the embodiment, descriptions of components that are substantially the same as those in the previous embodiment will be omitted.

Referring to FIG. 7, a first trench T1 and the second trench segment T2s may be disposed in the alignment key region B. The second trench segment T2s may extend in a direction parallel to the first direction FD. A first width W1 of each of the plurality of first trenches T1 in the first direction FD may be smaller than a second width W2 of at least one second trench segment T2s in the first direction FD. A third width W3 of at least one second trench segment T2s in a second direction SD crossing the first direction FD may be greater than half of the first width W1.

At least one second trench segment T2s may be disposed in a region other than a region (for example, corresponding to an area) between the plurality of first trenches T1 of the semiconductor device. A side of at least one second trench segment T2s adjacent to the chip region CR may be spaced apart from a respective side of each of the plurality of first trenches T1. A region in which each of the first trenches T1 is located may be between the chip region CR and a region in which at least one second trench segment T2s is located.

Because first trenches T1 adjacent in the second direction SD are spaced apart from each other, dicing may proceed in a straight manner (for example, along pre-defined dicing lanes without (unplanned) curves or deviations). Because the second trench segment T2s extends along the first direction FD, dicing may also proceed in a straight manner.

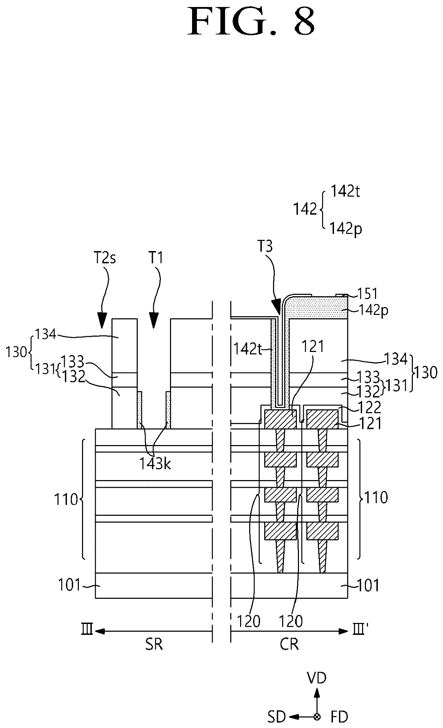

FIG. 8 is a cross-sectional view illustrating a cross-section along line III-III' of FIG. 7.

Referring to FIG. 8, the first trench T1 may be disposed in the scribe lane region SR. The second trench segment T2s may be disposed in the scribe lane region SR. A bottom surface of the second trench segment T2s may be coplanar with a bottom surface of the first trench T1. A depth of the second trench segment T2s may be equal to a depth of the first trench T1. The depth of the second trench segment T2s may be greater than the depth of the third trench T3.

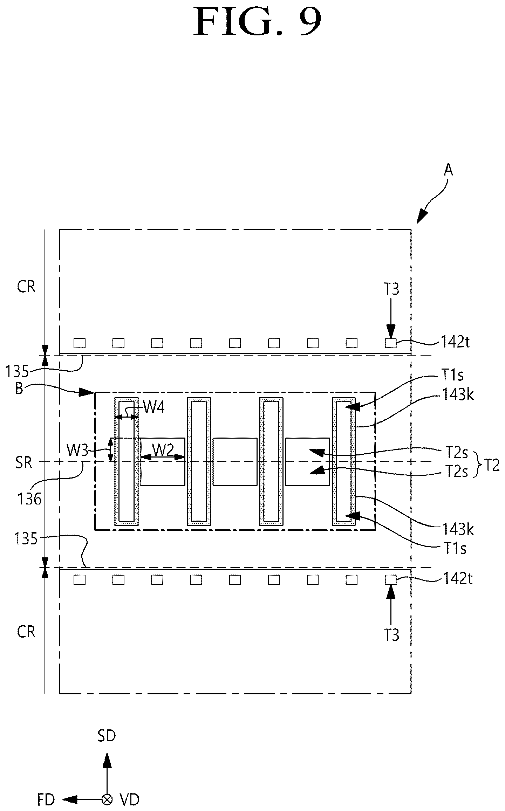

FIG. 9 is a plan view illustrating another embodiment of a semiconductor device disclosed in FIG. 1, showing an enlarged view of region A of FIG. 1.

The semiconductor device shown in FIG. 9 may be formed using the same method as the method of manufacturing a semiconductor device described with reference to FIG. 4 to FIG. 6.

Referring to FIG. 9, the first trench segment T1s and the second trench segment T2s may be disposed in the alignment key region B.

A fourth width W4 of each of the plurality of first trench segments T1s in the first direction FD may be less than a second width W2 of at least one second trench segment T2s in the first direction FD. A third width W3 of at least one second trench segment T2s in the second direction SD may be greater than half of the fourth width W4.

The second trench segment T2s may be disposed between first trench segments T1s that are adjacent to each other in the first direction FD. By disposing the second trench segment T2s between adjacent first trench segments T1s in the first direction FD, dicing may proceed in a straight manner during the dicing process.

A distance between at least one second trench segment T2s and the first boundary 135 may be greater than a distance between each of the plurality of first trench segments T1s and the first boundary 135.

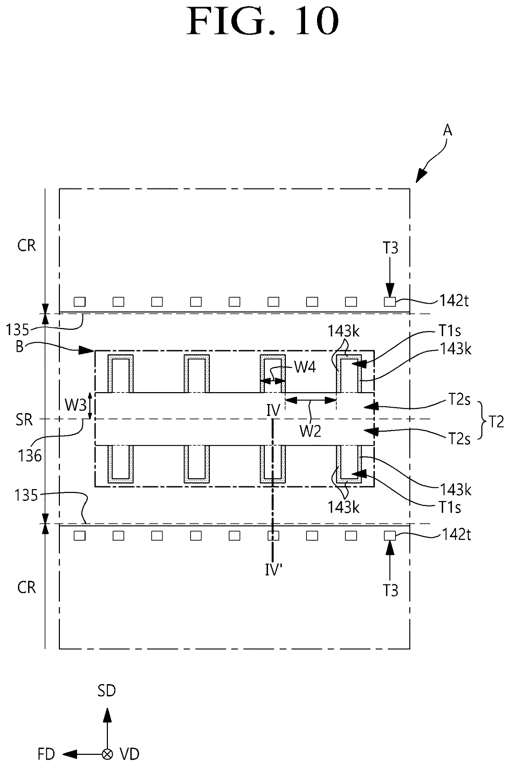

FIG. 10 is a plan view illustrating another embodiment of a semiconductor device disclosed in FIG. 1, showing an enlarged view of region A of FIG. 1.

The semiconductor device shown in FIG. 10 may be formed using the same method as the method of manufacturing a semiconductor device described with reference to FIG. 4 to FIG. 6.

Referring to FIG. 10, the first trench segment T1s and the second trench segment T2s may be disposed in the alignment key region B.

A distance between adjacent first trench segments T1s among the plurality of first trench segments may be equal to the second width W2.

A fourth width W4 of each of the plurality of first trench segments T1s in the first direction FD may be less than a second width W2 of at least one second trench segment T2s in the first direction FD. A third width W3 of at least one second trench segment T2s in the second direction SD may be greater than half of the fourth width W4.

Because the second width W2 is greater than the fourth width W4, redistribution material 141 in the second trench segment T2s may be removed. Because a bottom surface of the second trench segment T2s is larger than a bottom surface of the first trench segment T1s, the redistribution material 141 in the second trench segment T2s may be removed. Accordingly, the second trench segment T2s may guide dicing to proceed in a straight manner.

A distance between adjacent first trench segments T1s among the plurality of first trench segments may be equal to the second width W2.

A distance between at least one second trench segment T2s and the first boundary 135 may be greater than a distance between each of the plurality of first trench segments T1s and the first boundary 135.

Because the second trench segment T2s is disposed along the first direction FD, dicing may proceed in a straight manner during the dicing process.

The alignment pattern layer 143k may be disposed on a side surface of each of the plurality of first trench segments T1s.

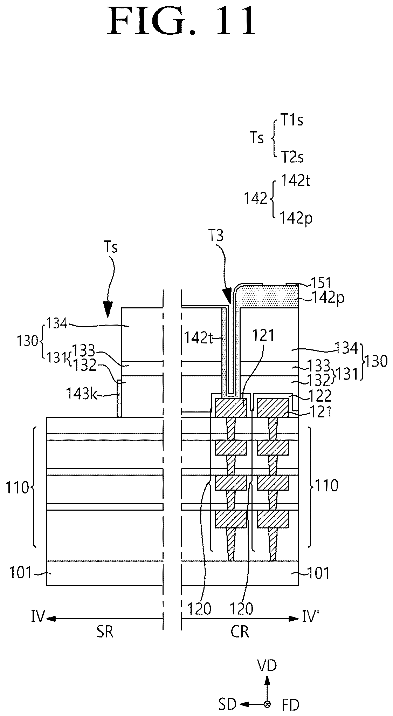

FIG. 11 is a cross-sectional view illustrating a cross-section along line IV-IV' of FIG. 10.

Referring to FIG. 11, a trench segment structure Ts may be disposed in the scribe lane region SR. The trench segment structure Ts may be defined to include the first trench segment T1s and the second trench segment T2s. The trench segment structure Ts may be located on the device layer 110. A bottom surface of the trench segment structure Ts may be in contact with a top surface of the device layer 110. The trench segment structure Ts may penetrate the insulating structure 130.

The above description is merely illustrative of the technical concept of the present disclosure, and various modifications and changes may be made by those skilled in the art without departing from the spirit and scope of the present disclosure. In addition, the embodiments described herein are intended to explain the technical concept of the present disclosure, and are not intended to limit the scope of the present disclosure. Therefore, the scope of the technical concept of the present disclosure should not be limited by these embodiments.

## Claims

1. A semiconductor device comprising:
a substrate including a chip region and a scribe lane region, the scribe lane region including a first boundary and a second boundary, the first boundary being adjacent to the chip region, the second boundary spaced apart from the first boundary;
a plurality of first trenches located between the first boundary and the second boundary, disposed in a first direction parallel to the first boundary, and having a first width in the first direction; and
at least one second trench segment having a second width in the first direction, the second width being greater than the first width.

2. The semiconductor device according to claim 1, wherein the at least one second trench segment has a third width in a second direction crossing the first direction, the third width being greater than half of the first width.

3. The semiconductor device according to claim 1, wherein a portion of the at least one second trench segment is disposed in a region between at least two of the plurality of first trenches.

4. The semiconductor device according to claim 1, wherein the at least one second trench segment extends in a direction parallel to the first direction.

5. The semiconductor device according to claim 4, wherein the at least one second trench segment is disposed in a region other than a region between the plurality of first trenches.

6. The semiconductor device according to claim 5, wherein a side of the at least one second trench segment adjacent to the chip region is spaced apart from a respective side of each of the plurality of first trenches.

7. The semiconductor device according to claim 4, wherein a region where each of the plurality of first trenches is located is between the chip region and a region where the at least one second trench segment is located.

8. The semiconductor device according to claim 1, wherein a depth of the at least one second trench segment is equal to a depth of each of the plurality of first trenches.

9. A semiconductor device comprising:
a substrate including a chip region and a scribe lane region;
a plurality of first trenches disposed in a first direction in the scribe lane region, the first direction being parallel to a first boundary adjacent to both the chip region and the scribe lane region; and
at least one second trench segment, at least a portion of which is disposed in a region other than a region between at least two of the plurality of first trenches,
wherein the plurality of first trenches has a first width in the first direction, the first width being less than a second width of the at least one second trench segment in the first direction.

10. The semiconductor device according to claim 9, wherein the at least one second trench segment has a third width in a second direction crossing the first direction, the third width being greater than half of the first width.

11. The semiconductor device according to claim 9, wherein a portion of the at least one second trench segment is disposed in a region between at least two of the plurality of first trenches.

12. The semiconductor device according to claim 9, wherein the at least one second trench segment extends in a direction parallel to the first direction.

13. The semiconductor device according to claim 12, wherein the at least one second trench segment is disposed in a region other than a region between the plurality of first trenches.

14. The semiconductor device according to claim 13, wherein a side of the at least one second trench segment adjacent to the chip region is spaced apart from a respective side of each of the plurality of first trenches.

15. The semiconductor device according to claim 12, wherein a region where each of the plurality of first trenches is located is between the chip region and a region where the at least one second trench segment is located.
